# EUROPEAN PATENT APPLICATION

(11) **EP 4 064 352 A2**
(43) Date of publication of application: **28.09.2022**
(21) Application number: 22163912.3
(22) Date of filing: 23.03.2022
(51) Int. Cl.: H01L 27/146

(54) **METHOD FOR MANUFACTURING SEMICONDUCTOR DEVICE**

(30) Priority: 25.03.2021 JP 2021051287; 25.03.2021 JP 2021051288
(71) Applicant: MITSUMI ELECTRIC CO., LTD., Tama-Shi, Tokyo 206-8567 (JP)
(72) Inventor: NAKANE, TAKETOMO, TAMA-SHI, 206-8567 (JP); HAYAKAWA, Etsuji, TAMA-SHI, 206-8567 (JP)
(74) Representative: Regimbeau

(57) **Abstract**

A method for manufacturing a semiconductor device includes providing a wafer that includes a device region and a peripheral region of the device region, the device region including multiple chip regions. The method includes removing a portion of the peripheral region such that the removed portion has an annular shape. The method includes forming a protective layer on a first surface of the wafer. The method includes grinding a second surface of the wafer in which the protective layer is formed on the first surface.

## Description

### BACKGROUND

### 1. Field of the Invention

The present disclosure relates to a method for manufacturing a semiconductor device.

### 2. Description of the Related Art

When semiconductor devices are manufactured, one or more elements are formed on one surface of a wafer, and then another surface of the wafer is grinded in order to reduce a thickness of the wafer to a predetermined thickness. The grinding is referred to as back grinding.

### [Related-art document]

### [Patent Document]

[Patent Document 1] Japanese Unexamined Patent Application Publication No. 2000-173961
[Patent Document 2] Japanese Unexamined Patent Application Publication No. 2004-22899
[Patent Document 3] Japanese Unexamined Patent Application Publication No. 2017-69276
[Patent Document 4] Japanese Unexamined Patent Application Publication No. 2014-154815
[Patent Document 5] Japanese Patent No. 5877663

### SUMMARY

In conventional methods, variations in a wafer thickness may occur in back grinding.

An object of one or more embodiments in the present disclosure is to provide a method for manufacturing a semiconductor device that can mitigate variations in a wafer thickness that is obtained in back grinding.

In one aspect of the present disclosure, a method for manufacturing a semiconductor device includes providing a wafer that includes a device region and a peripheral region of the device region, the device region including multiple chip regions. The method includes removing a portion of the peripheral region such that the removed portion has an annular shape. The method includes forming a protective layer on a first surface of the wafer. The method includes grinding a second surface of the wafer in which the protective layer is formed on the first surface.

In the present disclosure, variations in a wafer thickness that is obtained in back grinding can be mitigated.

### BRIEF DESCRIPTION OF THE DRAWINGS

Fig. 1 is a diagram for describing back grinding used when semiconductor chips with pillars are formed;
Fig. 2 is a cross-sectional view of an example of the configuration of a semiconductor device;
Fig. 3 is a plan view of an example of the semiconductor device from which a molding resin is removed;
Fig. 4 is a flowchart (first part) illustrating an example of the method for manufacturing a sensor chip according to a first embodiment;
Fig. 5 is a flowchart (second part) illustrating an example of the method for manufacturing the sensor chip according to the first embodiment;
Figs. 6A and 6B are plan views (first part) of an example of the sensor chip according to the first embodiment, the plan views being described for the method for manufacturing the sensor chip;
Figs. 7A and 7B are plan views (second part) of an example of the sensor chip according to the first embodiment, the plan views being described for the method for manufacturing the sensor chip;
Figs. 8A and 8B are cross-sectional views (first part) of an example of the sensor chip according to the first embodiment, the cross-sectional views being described for a method for manufacturing the sensor chip;
Figs. 9A and 9B are cross-sectional views (second part) of an example of the sensor chip according to the first embodiment, the cross-sectional views being described for the method for manufacturing the sensor chip;
Fig. 10 is a cross-sectional view (third part) of an example of the sensor chip according to the first embodiment, the cross-sectional view being described for the method for manufacturing the sensor chip;
Fig. 11 is a cross-sectional view (fourth part) of an example of the sensor chip according to the first embodiment, the cross-sectional view being described for the method for manufacturing the sensor chip;
Figs. 12A and 12B are cross-sectional views (first part) of an example of the semiconductor device according to the first embodiment, the cross-sectional views being described for the method for manufacturing the semiconductor device;
Figs. 13A and 13B are cross-sectional views (second part) of an example of the semiconductor device according to the first embodiment, the cross-sectional views being described for the method for manufacturing the semiconductor device;
Figs. 14A and 14B are cross-sectional views (third part) of an example of the semiconductor device according to the first embodiment, the cross-sectional views being described for the method for manufacturing the semiconductor device;
Figs. 15A and 15B are cross-sectional views (fourth part) of an example of the semiconductor device according to the first embodiment, the cross-sectional views being described for the method for manufacturing the semiconductor device;
Fig. 16 is a cross-sectional view of an example of the sensor chip that is excessively thick;
Fig. 17 is a cross-sectional view of an example of the sensor chip that is excessively thin;
Fig. 18 is a diagram (first part) illustrating the result of the measured thickness of the wafer that is obtained after back grinding;
Fig. 19 is a flowchart illustrating an example of the method for manufacturing the sensor chip according to a second embodiment; and
Fig. 20 is a diagram (second part) illustrating the result of the measured thickness of the wafer that is obtained after back grinding.

### DESCRIPTION OF THE EMBODIMENTS

One or more embodiments in the present disclosure will be described below in detail with reference to the drawings. In this description and the drawings, functional components each of which has substantially the same configuration are denoted by the same numerals, and description thereof may be omitted.

### (Recognition in the present disclosure)

In a process of manufacturing a semiconductor device, impurity regions, electrodes, lines, and the like are formed on a wafer with multiple chip regions, and then the wafer is cut to thereby form multiple semiconductor chips. Semiconductor chips may have a variety of configurations depending on the application. Some semiconductor chips include pillars. For the pillars, different materials and applications are adopted. For example, conductive pillars may be used as external electrodes for a semiconductor chip. In another application, the pillar may be used as a sacrificial layer when a molding resin is formed. Specifically, when the molding resin with which a sensor chip including a humidity detector is sealed is formed, the pillar is formed as a sacrificial layer so as to cover the humidity detector, and subsequently, after the molding resin is formed, the pillar is removed. The resulting opening, in which the humidity detector is exposed, is formed in the molding resin.

The inventors of this application have recognized that when a semiconductor device that includes one or more semiconductor chips with one or more pillars is manufactured, variations in a wafer thickness are likely to occur during back grinding. Also, the inventors have recognized that the variations in the wafer thickness occur in the following process. The description for the recognition will be provided below.

When the semiconductor chip with one or more pillars is formed, a given wafer obtained prior to cutting includes (i) a device region in which a plurality of chip regions with multiple pillars are collected and (ii) a peripheral region of the device region. The back grinding of the wafer is performed in a state in which the wafer is secured to a stage by applying a protective tape (hereafter may be referred to as a "back grinding (BG) tape") used for back grinding, to a top surface of the wafer.

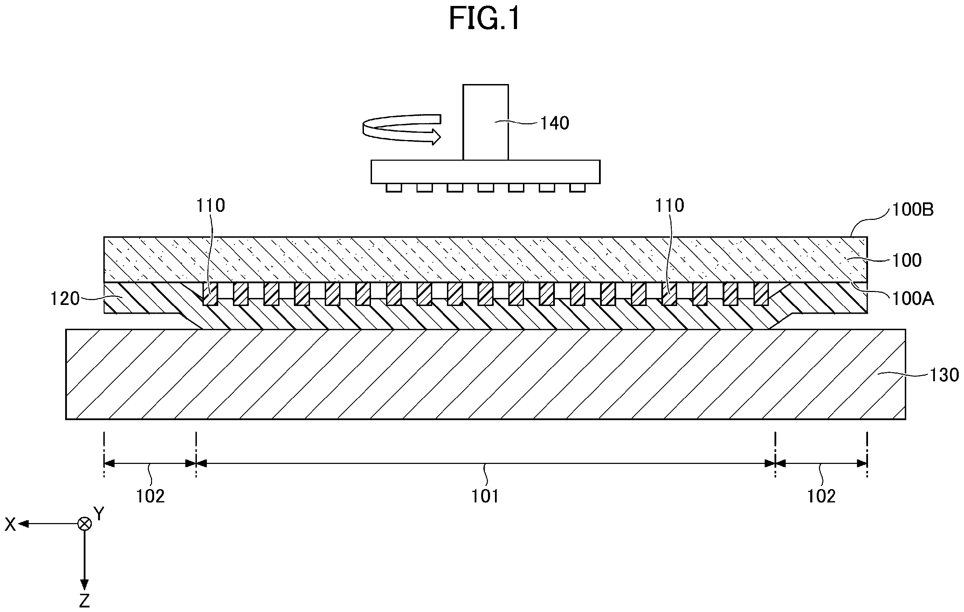

Fig. 1 is a diagram for describing back grinding used when semiconductor chips with pillars are formed. A plurality of pillars 110 are provided on one surface (top surface 100A) of a wafer 100, and a back grinding (BG) tape 120 is applied to the surface 100A of the wafer 100 so as to cover the pillars 110. Also, the front of the BG tape 120 is directed to a stage 130, and the wafer 100 is secured to the stage 130. Another surface (back side 100B) of the wafer 100 is grinded using a grinder 140. Each pillar 110 has a height in a Z-direction perpendicular to the surface 100A. An X-direction and Y-direction that are perpendicular to the Z-direction and are perpendicular to each other are parallel to the surface 100A.

The wafer 100 includes a device region 101 in which a plurality of chip regions including pillars 110 are collected, and includes a peripheral region 102 of the device region 101. As the dimension of each pillar 110 in the Z-direction is increased, the BG tape 120 is unlikely to enter a space between pillars 110. In this case, as illustrated in Fig. 1, the BG tape 120 contacts the stage 130 with respect to the device region 101, but does not contact the stage 130 with respect to the peripheral region 102. Thus, a space may be provided between the BG tape 120 and the stage 130. In the back grinding, the grinder 140 presses against the wafer 100. However, when the space is formed between the BG tape 120 and the stage 130, the wafer 100 may deflect at the space. When deflection of the wafer 100 occurs, a portion of energy caused by the pressed wafer is consumed through the deflection. In view of the situation described above, even in the back grinding of the device region 101, pressure acting on the wafer 100 through the grinder 140 tends to be reduced toward a wafer portion closer to the peripheral region 102. Thus, variations in the thickness of the wafer 100 during back grinding may occur. Likewise, if a smaller distance between two adjacent pillars 110 is obtained in an XY plane, variations in the thickness of the wafer 100 may occur during back grinding.

In view of the recognition by the inventors, the following embodiments are described in order to reduce the variations in the wafer thickness that are caused by the process described above.

### (First embodiment)

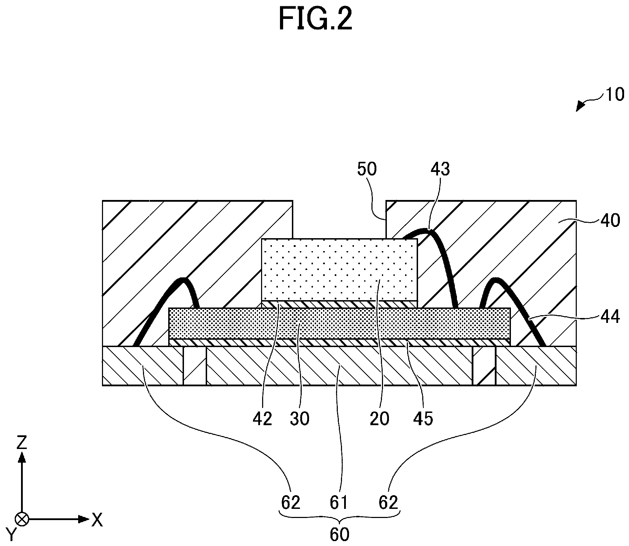

A semiconductor device manufactured according to the first embodiment will be described below. The semiconductor device is, for example, a humidity detecting device with a humidity detector. A manufacturing method will be described later in detail. When sealing is performed with resin, a pillar to be a sacrificial layer is disposed on the humidity detector, and then the pillar is removed after sealing is performed with the resin. In such a manner, an opening in which the humidity detector is exposed is formed in a molding resin. Fig. 2 is a cross-sectional view of an example of the semiconductor device.

A plane shape of the semiconductor device 10 manufactured according to the first embodiment is an approximate rectangle in which one pair of opposite sides is parallel to the X-direction and another pair of opposite sides is the Y-direction. The X-direction and Y-direction are perpendicular to each other. The semiconductor device 10 has a thickness in the Z-direction perpendicular to the X-direction and the Y-direction. The planar shape of the semiconductor device 10 is not limited to the rectangle, and may be a circle, an ellipse, a polygon, or the like.

The semiconductor device 10 includes a sensor chip 20 that is a first semiconductor chip, and includes an application specific integrated circuit (ASIC) chip 30 that is a second semiconductor chip. The semiconductor device 10 also includes a molding resin 40 and a lead frame 60.

The lead frame 60 includes a die pad 61 and a plurality of lead terminals 62. The thickness of the lead frame 60 may be in the range of from 100 µm through 200 µm, for example.

The ASIC chip 30 is laminated on the die pad 61 via a second die attach film (DAF) 45. The sensor chip 20 is laminated on the ASIC chip 30 via a first DAF 42. That is, the sensor chip 20 and the ASIC chip 30 are formed to have a stacked structure in which the sensor chip 20 is laminated on the ASIC chip 30. The thickness of the sensor chip 20 may be, for example, in the range of from 200 µm through 400 µm. The thickness of the ASIC chip 30 may be, for example, in the range of from 100 µm through 150 µm. The thickness for each of the first DAF 42 and the second DAF 45 is, for example, in the range of from 10 µm through 30 µm.

The sensor chip 20 and the ASIC chip 30 are electrically coupled to each other via a plurality of first bonding wires 43. The ASIC chip 30 and each of the lead terminals 62 are electrically coupled to each other via a given bonding wire among a plurality of second bonding wires 44.

The above laminated sensor chip 20 and ASIC chip 30, as well as the lead frame 60 that includes the plurality of first bonding wires 43 and the plurality of second bonding wires 44, are sealed and packaged with the molding resin 40 as a sealing member. The die pad 61 and the lead terminals 62 are exposed on the bottom surface of the semiconductor device 10. The thickness of a portion of the molding resin 40 that is higher than the sensor chip 20 can be, for example, in the range of from 50 µm through 500 µm, and preferably in the range of from 100 µm through 250 µm. The thickness of the semiconductor device 10 may be, for example, in the range of from 500 µm through 1000 µm.

The lead frame 60 is formed of nickel or copper. The first DAF 42 and the second DAF 45 are each formed of an insulating material that is made of a mixture or the like of resin and silica. The molding resin 40 is a light-blocking black resin, such as an epoxy resin containing a mixture or the like of carbon black and silica.

An opening 50 used to expose a portion of the sensor chip 20 in the molding resin 40 is formed on a top side of the semiconductor device 10. For example, a planar shape of the opening 50 is an approximate rectangle with both pairs of opposite sides, where one pair is parallel to the X-direction and another pair is parallel to the Y-direction. The length of each side of the rectangle is in the range of from 400 µm through 600 µm.

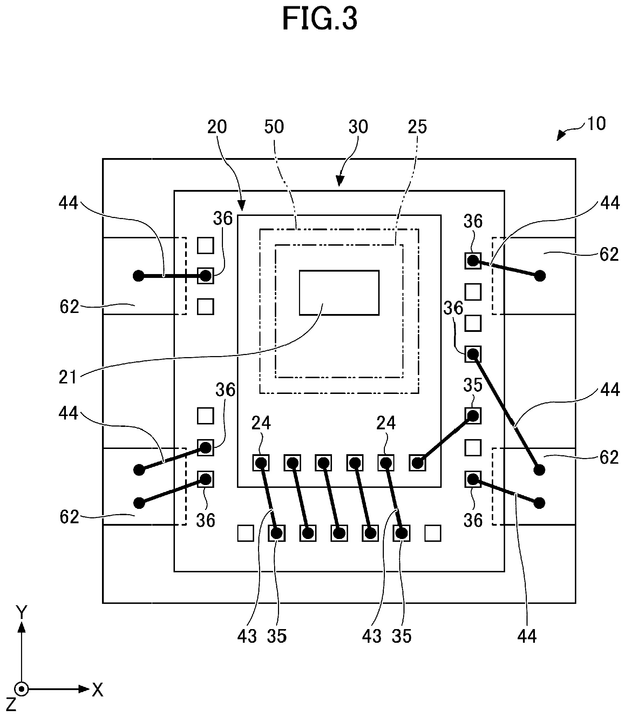

Fig. 3 is a plan view of the semiconductor device 10 from which the molding resin 40 is removed. As illustrated in Fig. 3, the planar shape of each of the sensor chip 20 and the ASIC chip 30 is an approximate rectangle with both pairs of opposite sides, where one pair is parallel to the X-direction, and another pair is parallel to the Y-direction. The sensor chip 20 is smaller than the ASIC chip 30 and is laminated above the surface of the ASIC chip 30 via the first DAF 42.

A humidity detector 21, a temperature detector (not illustrated), and a heater (not illustrated) are provided on a region of the sensor chip 20 that is exposed in the opening 50. The heater is formed below the humidity detector 21 so as to cover a formation region of the humidity detector 21. That is, the size of the heater is larger than that of the humidity detector 21. With this arrangement, the sensor chip 20 and the like are sealed with the molding resin 40 as the sealing member, in a state in which the humidity detector 21 and the temperature detector are exposed.

A plurality of bonding pads (hereafter may be simply referred to as "pads") 24 are also formed toward one edge of the sensor chip 20. Each pad 24 is formed of, for example, aluminum or an aluminum silicon alloy (AlSi).

The ASIC chip 30 is a semiconductor chip for signal processing and control, and includes, for example, a humidity measurement processor, a temperature measurement processor, a heat controller, and a fault determining unit.

A plurality of first pads 35 and a plurality of second pads 36 are provided in a region of the surface of the ASIC chip 30 that is not covered by the sensor chip 20. The first pads 35 and second pads 36 are each formed of, for example, aluminum or an aluminum silicon (AlSi) alloy.

The first pads 35 are coupled to the pads 24 of the sensor chip 20 via the first bonding wires 43, respectively. The second pads 36 are coupled to the lead terminals 62 via the second bonding wires 44, respectively. The lead terminals 62 are disposed around the ASIC chip 30.

During manufacture, a mounted position of the ASIC chip 30 is determined with reference to the lead terminals 62. A mounted position of the ASIC chip 30 over which the sensor chip 20 is mounted is determined with reference to either of the position of the ASIC chip 30 or the lead terminals 62.

The semiconductor device 10 has a formation permissible region 25 on which the humidity detector 21 and a temperature detector are to be disposed on the sensor chip 20. Even when a greatest offset of each of the ASIC chip 30 and the sensor chip 20, from a given mold is obtained during mounting of the sensor chip, the formation permissible region 25 is set within a formation region of a given opening 50, such that the humidity detector 21 and the temperature detector are reliably exposed in the given opening. When the humidity detector 21 and the temperature detector are formed within the formation permissible region 25, these detectors are reliably exposed in the opening 50, regardless of the above-described offset.

The semiconductor device 10 manufactured according to the first embodiment has the above-described configuration.

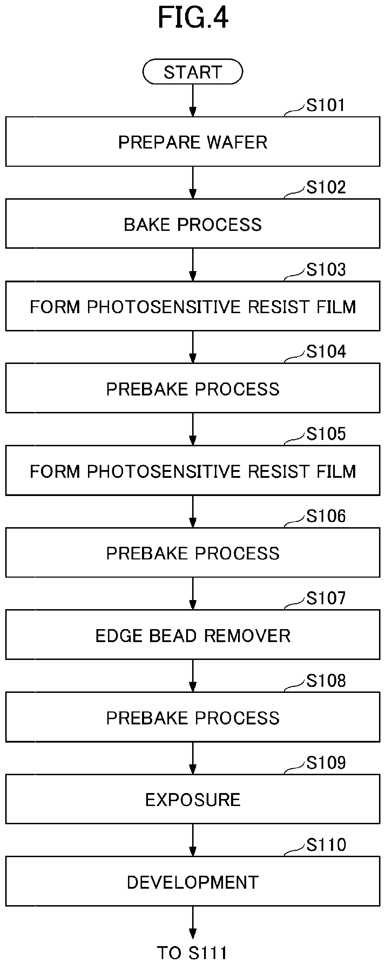

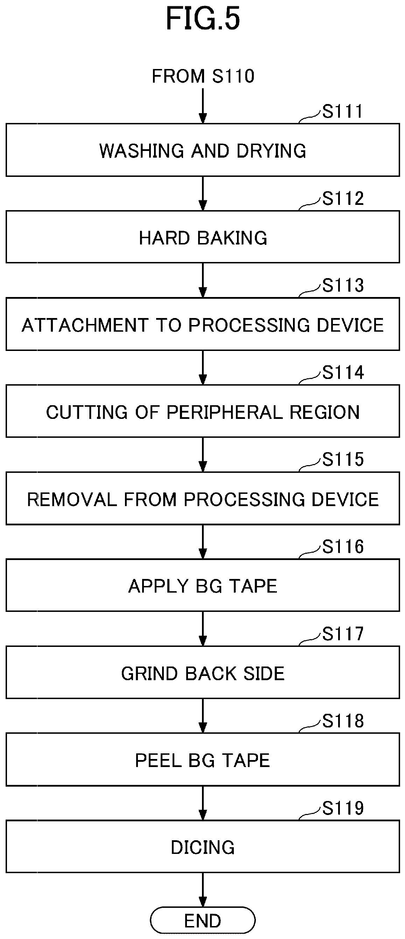

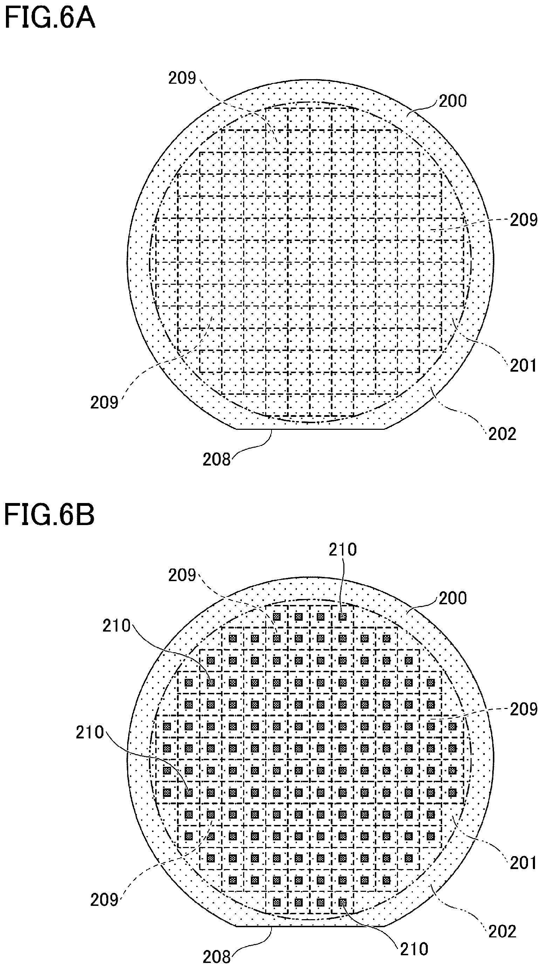

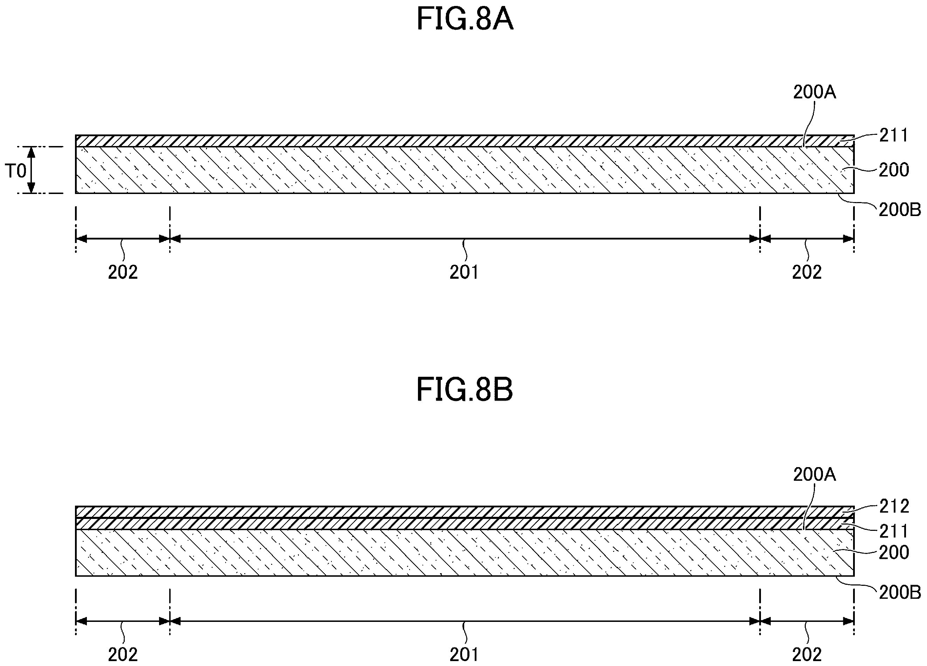

Hereafter, a method for manufacturing the semiconductor device according to the first embodiment will be described. The process of manufacturing the sensor chip 20 will be described first. Figs. 4 and 5 are flowcharts illustrating an example of the method for manufacturing the sensor chip 20 according to the first embodiment. Figs. 6A to 7B are plan views of an example of the sensor chip 20 according to the first embodiment, and the plan views are described for the method for manufacturing the sensor chip 20. Figs. 8A to 11 are cross-sectional views of an example of the sensor chip 20 according to the first embodiment, and the cross-sectional views are described for the method for manufacturing the sensor chip 20.

As illustrated in Fig. 6A, a wafer 200 having a plurality of chip regions 209 is prepared (step S101). The wafer 200 has a device region 201 in which the chip regions 209 are collected, and has a peripheral region 202 of the device region 201. One sensor chip 20 is obtained for a corresponding single chip region 209. On one surface (top surface 200A) of the wafer 200, each chip region 209 includes a humidity detector 21, a temperature detector, a heater, electrodes, lines, and the like. An orientation flat 208 is formed in the wafer 200. A thickness T0 of the wafer 200 is greater than the thickness of the sensor chip 20, and is in the range of from 600 µm through 650 µm, for example. The diameter of the wafer 200 is, for example, 6 inches (15.24 cm). Each chip region 209 has an approximately rectangular planar shape with both pairs of opposite sides, where one pair is parallel to the X-direction, and another pair is parallel to the Y-direction. For example, the length for each side of the one pair that is parallel to the X-direction is in the range of from 900 µm through 1100 µm. Also, the length for each side of the another pair that is parallel to the Y-direction is in the range of from 600 µm through 800 µm. The material of the wafer 200 includes, for example, silicon (Si), silicon carbide (SiC), aluminum nitride (AlN), alumina (Al₂O₃), gallium nitride (GaN), gallium arsenide (GaAs), or the like.

Then, baking is performed in order to remove moisture contained in the wafer 200 (step S102). For example, a baking temperature is in the range of from 100 °C through 150 °C, and the baking time is applied for 1 minute to 3 minutes.

Then, the process of forming pillars, which are to be sacrificial layers, is performed, where the pillars are respectively formed at locations at which openings 50 are to be formed. In this case, as illustrated in Fig. 8A, a photosensitive resist film 211, with which the pillars are to be formed on the surface 200A of the wafer 200, is formed by spin coating (step S103). The photosensitive resist film 211 is formed by rotating the wafer at a rotation speed in the range of from 300 rpm through 600 rpm, for example. The thickness of the photosensitive resist film 211 is, for example, in the range of from 50 µm through 100 µm. After the photosensitive resist film 211 is formed, an edge rinse of the wafer 200 is performed. If a larger amount of the photosensitive resist film 211 that is moved to the back side of the wafer 200 is obtained, a back rinse may be also performed as necessary.

Then, a prebake of the photosensitive resist film 211 is performed (step S104). For example, a prebake temperature is 100 °C through 150 °C, and a prebake time is applied for 5 minutes to 10 minutes. With use of the prebake, solvents contained in the photosensitive resist film 211 are removed.

In the present embodiment, in order to perform wire bonding around the opening 50 that is within a region of the sensor chip 20 to be formed in a subsequent process, a resin thickness needs to exceed a given wire height. Also, the height of the opening 50 needs to have a height that is similar to the resin thickness. However, it is difficult to set an appropriate height of the photosensitive resist film, with a single application. For this reason, as illustrated in Fig. 8B, the photosensitive resist film 212 is formed on the photosensitive resist film 211 by spin coating that is performed again (step S105). The photosensitive resist film 212 is formed by rotating the wafer at rotation speed ranging from 300 rpm through 600 rpm, for example. The thickness of the photosensitive resist film 212 is, for example, in the range of from 50 µm through 100 µm. When the thickness of the photosensitive resist film 211 and the thickness of the photosensitive resist film 212 are summed, a total sum of thicknesses of the photosensitive resist films 211 and 212 becomes, for example, greater than or equal to 100 µm and less than or equal to 200 µm. After the photosensitive resist film 212 is formed, the edge rinse of the wafer 200 is performed.

Then, the prebake of the photosensitive resist film 212 is performed (step S106). For example, a prebake temperature is in the range of from 100 °C through 150 °C, and the prebake time is applied for 5 minutes to 10 minutes. With use of the prebake, the solvent contained in the photosensitive resist film 212 is removed.

Then, the edge rinse of the wafer 200 is performed (step S107). After the prebake in step S106, the edge rinse is performed, and thus a solvent, which is not completely removed by the edge rinse that performed after the process of step S105 in which the photosensitive resist film 212 is formed, can be removed.

Then, the prebake of the wafer 200 is performed (step S108). For example, the prebake temperature is in the range of from 100 °C through 150 °C, and the prebake time is applied for 5 minutes to 10 minutes. With use of the prebake, the solvent adhered to the wafer 200 in the edge rinse in step S107 can be removed.

Then, the photosensitive resist films 211 and 212 are exposed (step S109). The exposure is performed so as to correspond to each opening 50 to be formed on the sensor chip 20. For example, an i-ray, a g-ray, or an h-ray can be used for the exposure, and the ray energy is in the range of from 500 mJ through 550 mJ.

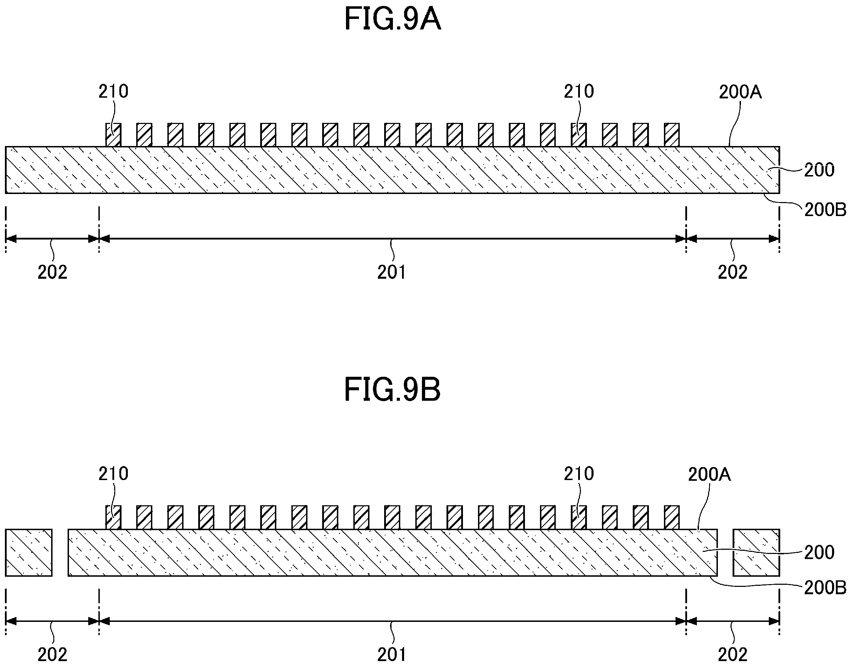

Then, the photosensitive resist films 211 and 212 are developed (step S110). As a result, as illustrated in Fig. 6B and Fig. 9A, the pillar 210 of the photosensitive resist is formed on each chip region 209. For example, the pillar 210 has a squarely planar shape, and the length of each side of the square planar shape is in the range of from 400 µm through 600 µm. The height of the pillar 210 may be in the range of from 100 µm through 200 µm in the above mentioned process, but may be appropriately set in the range of from 50 µm through 500 µm, for example.

The wafer 200 is then washed and dried (step S111). For washing, for example, pure water is used. For example, a spin dryer is used for drying. For example, the rotation speed is in the range of from 800 rpm through 1200 rpm, and processing time is in the range of from 8 minutes through 12 minutes.

Then, hard baking of the wafer 200 is performed (step S112). For example, a hard baking temperature is in the range of from 150 °C through 200 °C, and a hard baking time is applied for 15 minutes to 25 minutes. With use of the hard baking, moisture remaining in the wafer 200, as well as solvents remaining in the pillars 210, can be removed.

In such a manner, the wafer 200 in which the pillars 210 are provided on the surface 200A is obtained. The pillars 210 are formed on the device region 201.

Then, a dicing tape is applied to another surface (back side 200B) of the wafer 200 and the wafer 200 is attached to a processing device (step S113). For example, a dicing machine specified by "DFD6361" by Disco Corporation can be used as the processing device.

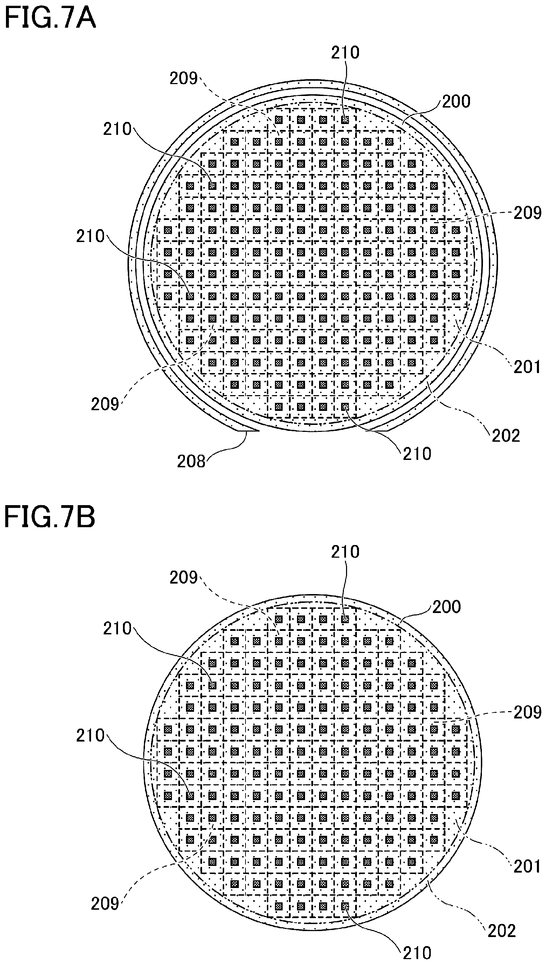

Then, as illustrated in Fig. 7A and Fig. 9B, the peripheral region 202 of the wafer 200 is cut such that a cutout has an annular shape (step S114). As a result, the peripheral region 202 is cut along a circle of which the radius is smaller than the radius of the wafer 200 to be separated into two regions. A separated outer region is removed. In the cutting, an edge tangent of the wafer 200 obtained after the cutting may correspond to the orientation flat 208. That is, the edge of the wafer 200 obtained after the cutting may be positioned at the orientation flat 208. The edge of the wafer 200 obtained after the cutting may be also located closer to the center of the wafer 200 than the orientation flat 208.

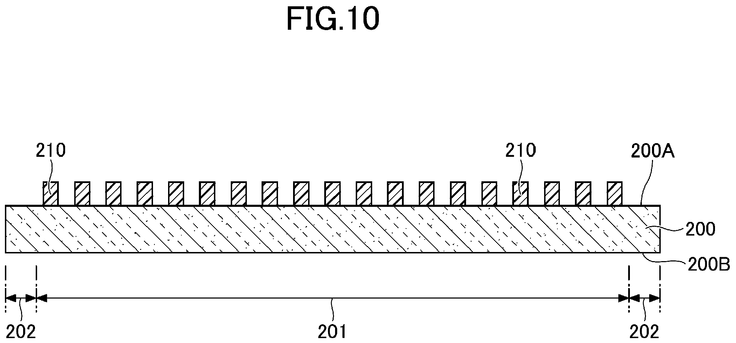

Then, a dicing tape is irradiated with ultraviolet light so that adhesion of the dicing tape is reduced, and then the wafer 200 is removed from the processing device (step S115). As a result, the wafer 200 from which a portion of the peripheral region 202 is removed is obtained, as illustrated in Fig. 7B and Fig. 10.

Then, a BG tape 220 is applied to the surface 200A of the wafer 200 so as to overlap exposed ends of the pillars, and thus the pillars 210 are covered by the BG tape 220 (step S116). In this case, the BG tape 220 contacts the peripheral region 202 over the entire perimeter of the wafer 200. If a space between the BG tape 220 and the peripheral region 202 is provided, water for cutting may enter the surface 200A of the wafer 200 during back grinding. The BG tape 220 is an example of a protective layer.

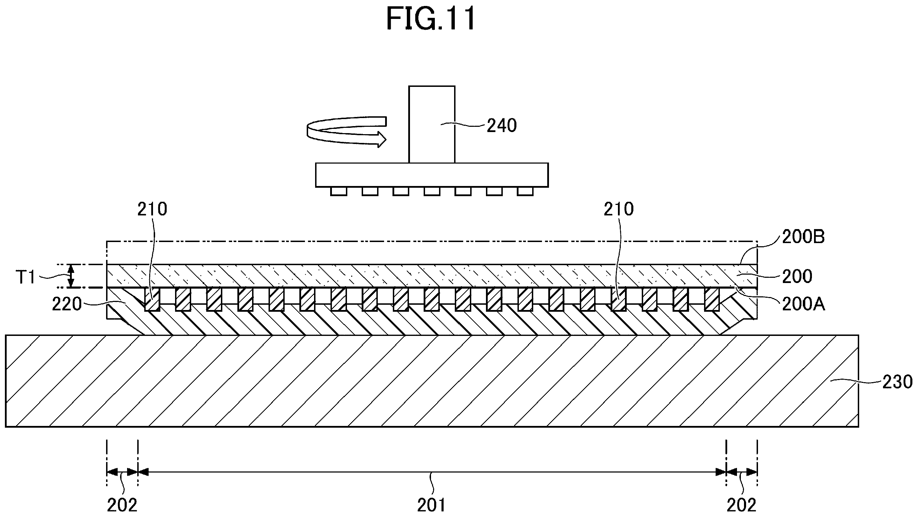

Then, as illustrated in Fig. 11, the front of the BG tape 220 is directed to the stage 230, and the wafer 200 is secured to the stage 230. Then, the back side 200B of the wafer 200 is grinded using a grinder 240 (step S117). The back grinding is performed while the grinder 240 is pressed against the wafer 200. The thickness T1 of the wafer that is obtained after the back grinding is approximately the same as that of the sensor chip 20, and is in the range of from 200 µm through 400 µm, for example.

In step S114, the portion of the peripheral region 202 is removed, and thus in the back grinding in step S117, deflection of the wafer 200 is mitigated. In such a manner, the in-plane wafer uniformity of pressure that acts on the wafer 200 through the grinder 240 is approximately obtained. Therefore, the in-plane wafer uniformity of the thickness for the wafer 200 that is obtained after the back grinding of the back side 200B is increased excellently.

Then, the BG tape 220 is irradiated with ultraviolet light so that adhesion of the BG tape 220 is reduced, and then the BG tape 220 is removed from the wafer 200 (step S118).

Then, the wafer 200 is diced to be separated into a plurality of chip regions 209 (step S119).

In such a manner, sensor chips 20 including multiple pillars 210 are manufactured.

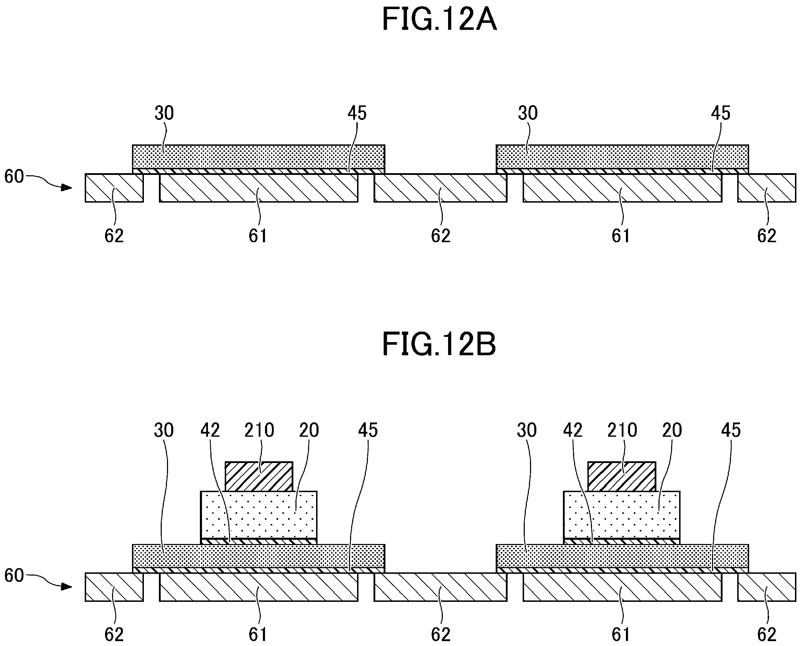

Hereafter, the process of manufacturing the semiconductor device 10 by using both the sensor chip 20 with the pillar 210 and the ASIC chip 30 will be described. Figs. 12 to 15B are cross-sectional views of the semiconductor device 10, and the cross-sectional views are described for the method for manufacturing the semiconductor device 10.

As illustrated in Fig. 12A, the lead frame 60 with the die pad 61 and lead terminals 62 is prepared, and a plurality of ASIC chips 30 are secured to the die pad 61 via the second DAF 45. In practice, although a greater number of ASIC chips 30 are secured to the die pad 61, only two sensor chips 20 are illustrated in Fig. 12A for the sake of explanation. Each ASIC chip 30 is manufactured to be separate from the sensor chips 20.

Then, as illustrated in Fig. 12B, the sensor chip 20 with the pillar 210 is secured to the surface of each ASIC chip 30 via the first DAF 42.

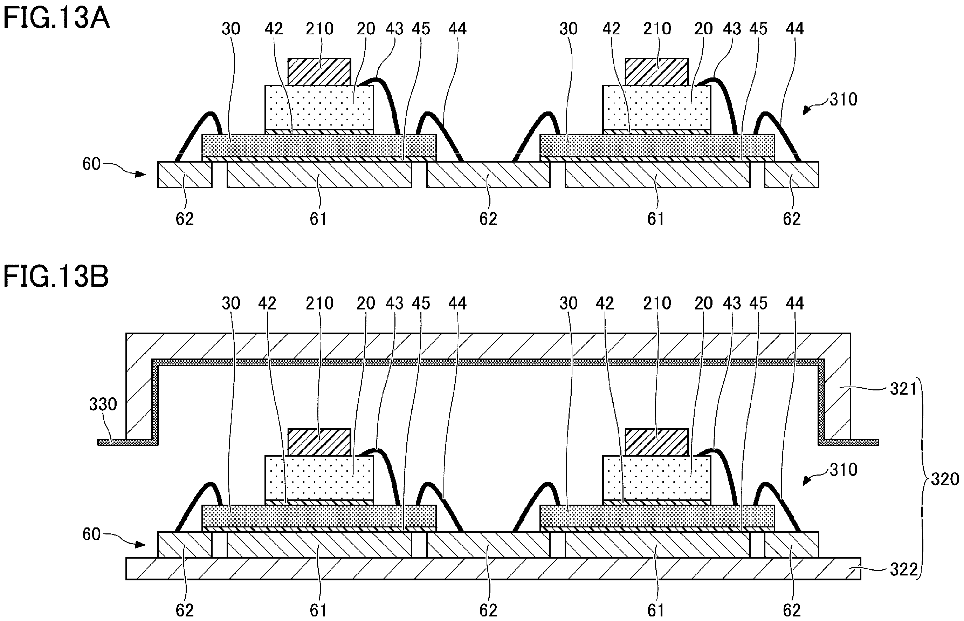

Then, as illustrated in Fig. 13A, second pads 36 on each ASIC chip 30, and lead terminals 62 are coupled together via second bonding wires 44, respectively. Also, pads 24 on each sensor chip 20, and first pads 35 on a given ASIC chip 30 are coupled together via first bonding wires 43, respectively. In the following description, the object illustrated in Fig. 13A may be referred to as a target article 310 to be molded.

Then, as illustrated in Fig. 13B, a mold 320 consisting of an upper mold 321 and a lower mold 322 is prepared, and the target article 310 is mounted on the lower mold 322. The mold 310 is a transfer mold for resin sealing. A releasing film 330 is provided on the inner surface of the upper mold 321. The releasing film 330 has a region that covers the entire inner surface of the upper mold 321. The releasing film 330 has heat resistance that can withstand a heating temperature during resin molding. Also, the releasing film 330 has a peeling property that enables the releasing film to be easily peeled from the molding resin 40 and the mold 320. The releasing film 330 is formed by, for example, ethylene-tetrafluoroethylene (ETFE).

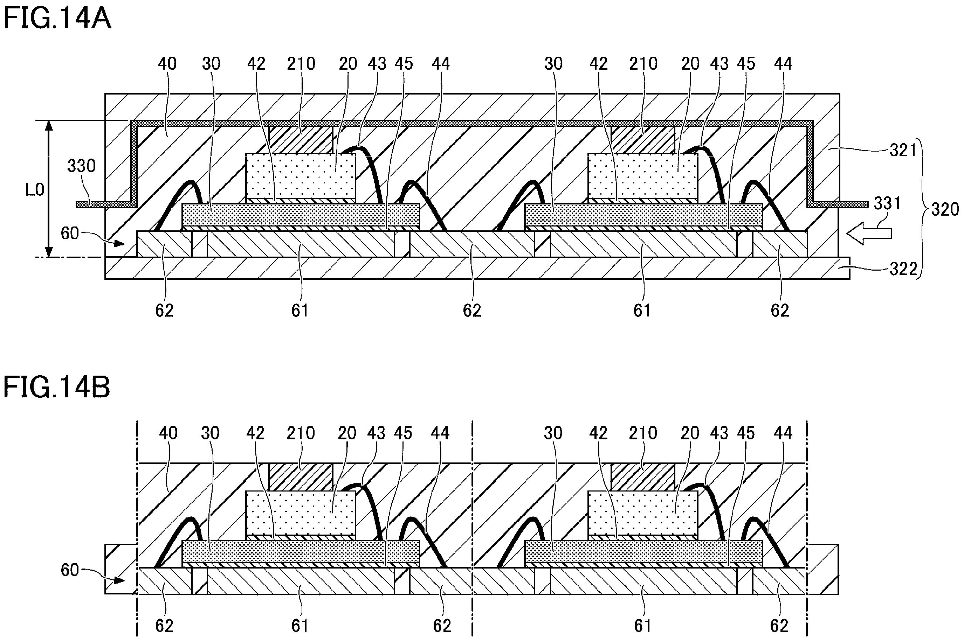

Then, as illustrated in Fig. 14A, the upper mold 321 is connected to the lower mold 322 via the releasing film 330. In this case, a distance L0 between the upper surface of the lower mold 322 and the lower surface of the upper mold 321 is preset to a value corresponding to the thickness of the semiconductor device 10.

With this arrangement, in a state in which the upper mold 321 and the lower mold 322 are connected to each other via the releasing film 330, while heating the mold 320, the molding resin 40 is supplied to an interior space of the mold 320 through a supply path, as expressed by the arrow 331. In such a manner, the sensor chips 20, the ASIC chips 30, the first bonding wires 43, the second bonding wires 44, and the lead frame 60 are sealed with the molding resin 40. The heating temperature for the mold 320 may be, for example, in the range of from 160 °C through 200 °C.

After the molding resin 40 is solidified, the upper mold 321 is separated from the lower mold 322, as illustrated in Fig. 14B. Then, (i) the sensor chips 20 with the respective pillars 210, (ii) the ASIC chips 30, (iii) the first bonding wires 43, (iv) the second bonding wires 44, and (v) the lead frame 60, which are sealed with the molding resin 40, are removed from the mold 320. The releasing film 330 is peeled from the molding resin 40 and the pillars 210.

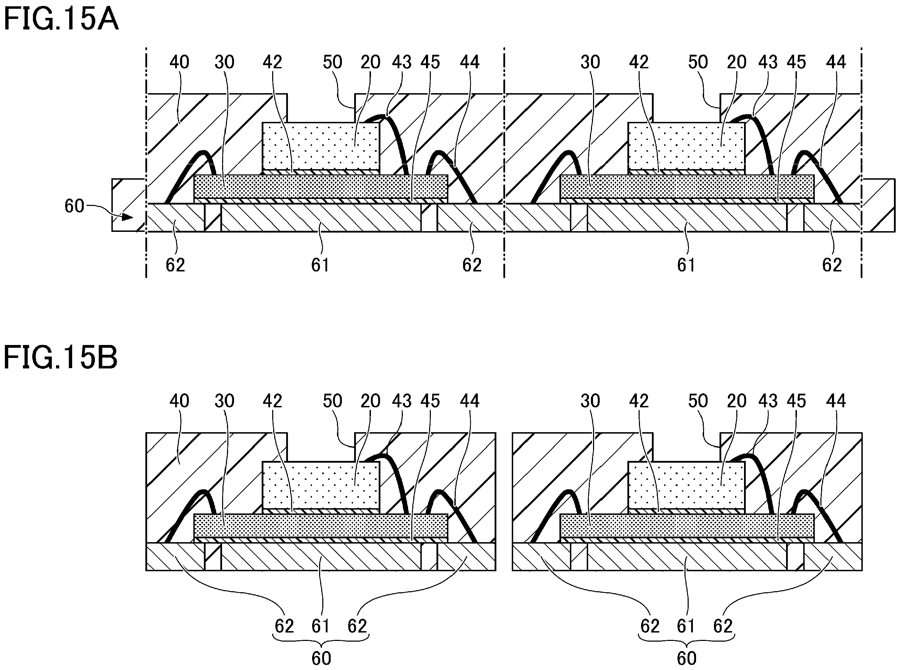

Then, as illustrated in Fig. 15A, the pillars 210 are removed. For example, the pillars 210 can be removed by ashing. Openings 50 are each formed in a portion at which a corresponding pillar 210 is removed. Instead of ashing, solutions can be used to remove the pillars in consideration of the material of the pillars 210.

The molding resin 40 and the lead frame 60 are then cut, as illustrated in Fig. 15B.

In such a manner, a plurality of semiconductor devices 10 are manufactured.

In the present embodiment, as described above, because the portion of the peripheral region 202 is removed in step S114, deflection of the wafer 200 is mitigated in the back grinding in step S117. Thus, the in-plane wafer uniformity of pressure that acts on the wafer 200 through the grinder 240 is approximately obtained. Therefore, the in-plane wafer uniformity of the thickness for the wafer 200 that is obtained after the back grinding of the back side 200B is increased excellently.

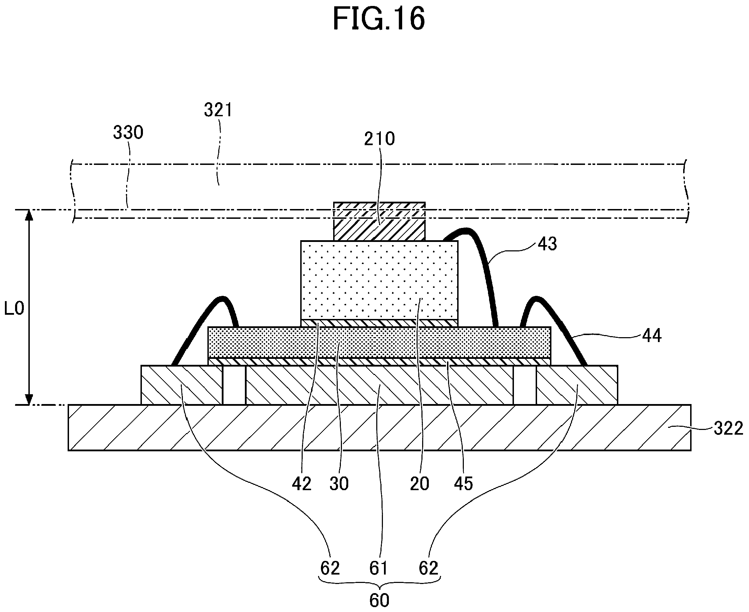

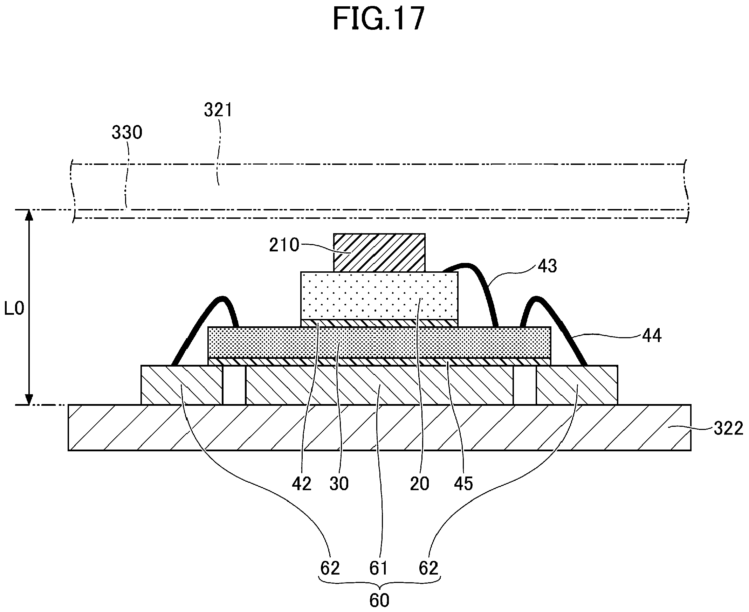

Hereafter, an example in which the sensor chip 20 becomes excessively thick, as well as an example in which the sensor chip 20 becomes excessively thin, will be described. Fig. 16 is a cross-sectional view of an example of the sensor chip 20 that is excessively thick. Fig. 17 is a cross-sectional view of an example of the sensor chip 20 that is excessively thin.

As described previously, the distance L0 between the upper surface of the lower mold 322 and the lower surface of the upper mold 321 is preset to a value corresponding to the thickness of the semiconductor device 10. In this case, when the sensor chip 20 becomes excessively thick, an excessively great distance from the lower surface of the lead frame 60 to the upper surface of the pillar 210 is obtained, as illustrated in Fig. 16. Therefore, when the upper mold 321 and the lower mold 322 are connected to each other, a greater distance L0 between the upper surface of the lower mold 322 and the lower surface of the upper mold 321 is obtained, and thus greater compression pressure is applied to the sensor chip 20 and the ASIC chip 30, which may result in damage to the sensor chip 20 and the ASIC chip 30. Also, when the pillar 210 is compressed, one or more first bonding wires 43 contact the releasing film 330, and thus the first bonding wires 43 may be exposed on the molding resin 40 without being sealed with the molding resin 40.

When the sensor chip 20 becomes excessively thin, an excessively small distance from the lower surface of the lead frame 60 to the upper surface of the pillar 210 is obtained, as illustrated in Fig. 17. Therefore, when the upper mold 321 and the lower mold 322 are connected to each other, a greater distance L0 between the upper surface of the lower mold 322 and the lower surface of the upper mold 321 is obtained, and thus a space may be formed between the upper surface of the pillar 210 and the lower surface of the upper mold 321. When such a space is formed, the molding resin 40 enters the space, and thus the pillar 210 cannot be removed in a subsequent process. As a result, there may be cases in which the opening 50 cannot be formed.

According to the present embodiment, the sensor chip 20 having a desired thickness can be formed, thereby avoiding the issues described in Fig. 16 and Fig. 17 above.

For example, the material of the photosensitive resist films 211 and 212 includes a novolac-based resin, an acrylic-based resin, or a polyimide-based resin. In this case, the material of the pillar 210 includes, for example, a novolac resin, an acrylic resin, or a polyimide resin. Instead of spin coating of the liquid resist, a film-like resist may be applied.

Each pillar 210 is formed from the photosensitive resist films 211 and 212. However, when the pillar 210 having an appropriate height is formed from one photosensitive resist film, it is not necessary to form both the photosensitive resist films 211 and 212. Three or more photosensitive resist films may be formed to form pillars 210 each of which has a greater height.

A distance between the edge of the wafer 200, which is obtained after the cutting in step S114, and a given pillar 210 that is closest to the edge of the wafer 200 and is among the plurality of pillars 210, is preferably greater than or equal to 1.0 times and less than or equal to 5.0 times the height of the given pillar 210, and more preferably greater than or equal to 1.2 times and less than or equal to 4.0 times the height of the given pillar 210. Also, such a distance is more preferably greater than or equal to 1.5 times and less than or equal to 3.0 times the height of the given pillar 210. Although the distance between the edge of the wafer 200 and the given pillar 210 depends on the height of the given pillar 210, it may be, for example, in the range of from 50 µm through 1500 µm. As the distance between the edge of the wafer 200 and the given pillar 210 is increased, deflection of the wafer 200 is likely to be increased during the back grinding, and thus the effect of reducing variations in a wafer thickness may be mitigated. In contrast, as the distance between the edge of the wafer 200 and the given pillar 210 is decreased, the BG tape 220 is unlikely to become in close contact with the peripheral region 202.

The planar shape of each pillar 210 is not limited to a rectangle, and may include a polygon other than the rectangle, a circle, an ellipse, or the like.

The material of each pillar is not limited to the photosensitive resist. For example, the pillar material may be a non-photosensitive material such as cellulose. For example, acetone is used as a solvent for cellulose, an acetone solution for cellulose is applied through spin coating, and then the acetone is removed by baking. The coating and baking are repeated to form a cellulose film having a desired thickness. Subsequently, a typical novolac-based photosensitive resist or the like is applied, and then exposing and developing are performed. In this process, a resist mask is formed to cover a region in which pillars are to be formed and to expose the other region. An exposed portion of the resist mask, as the cellulose film, is then removed by using acetone or by reactive ion etching (RIE). Then, the resist mask is removed using butyl acetate. In such a process, one or more pillars from a non-photosensitive film can be formed.

Hereafter, with use of actual measured values, the effect obtained in the first embodiment will be described by being compared with the effect obtained in a reference example.

In a first example according to the first embodiment, for a given wafer, the thickness was 625 µm and the diameter was 6 inches (15.24 cm). In step S114 in which cutting was performed, the wafer was cut along a circle of which the perimeter is at a distance of 3 mm from the edge of the wafer. In other words, the wafer diameter was reduced by 6 mm. In step S117 in which back grinding was performed, a target thickness A of the wafer to be obtained after the back grinding was set to 300 µm.

In the reference example (second example), in step S114, cutting was not performed. In step S117 in which back grinding was performed, a target thickness B of the wafer to be obtained after the back grinding was set to 464 µm. Other conditions were the same as those described in the first example.

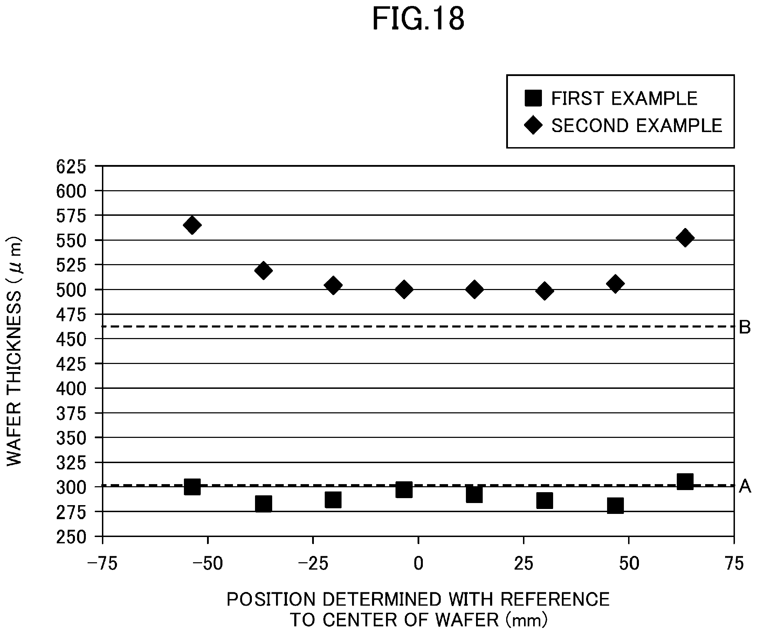

In each of the first example and the second example, the thickness of the wafer that was obtained after the back grinding was measured. The result is illustrated in Fig. 18. In Fig. 18, the horizontal axis expresses the position determined with reference to the center of the wafer, and the vertical axis expresses the wafer thickness. A negative value in the horizontal axis corresponds to the position in a direction opposite to a positive direction.

As illustrated in Fig. 18, in the first example (see "■"), the wafer thicknesses were in the range of ±20 µm with respect to the target thickness A of 300 µm. A difference between a maximum value and a minimum value was only 26 µm. In contrast, in the second example (see "◆"), although the target thickness B was 464 µm, the thickness for all of the wafer thicknesses was about 500 µm or more. A difference between the maximum value and the minimum value was about 70 µm, which was greater than that obtained in the first example.

### (Second embodiment)

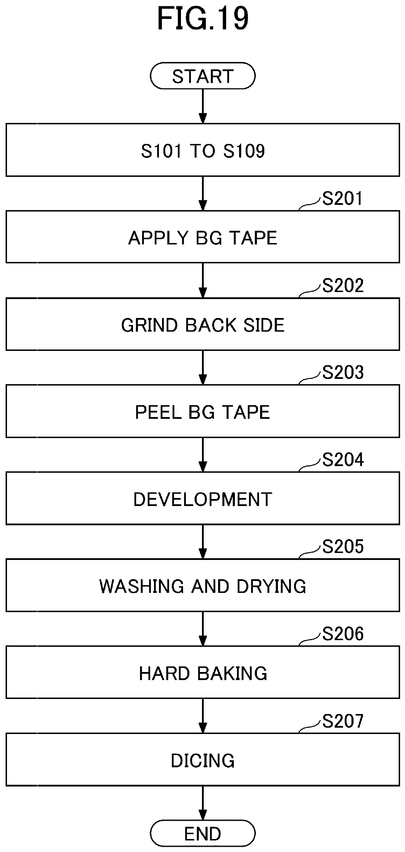

A second embodiment will be described. The second embodiment differs from the first embodiment in a method for manufacturing the sensor chip 20. Fig. 19 is a flowchart illustrating an example of the method for manufacturing the sensor chip 20 according to the second embodiment.

In the second embodiment, the process in steps S101 to S109 are performed, as in the first embodiment.

Then, the BG tape 220 is applied to the surface 200A of the wafer 200 so as to overlap exposed photosensitive resist film 212, and thus the developed photosensitive resist films 211 and 212 are covered by the BG tape 220 (step S201).

Then, the front of the BG tape 220 is directed to the stage 230, and the wafer 200 is secured to the stage 230. Subsequently, the grinder 240 is used to grind the back side 200B of the wafer 200 (step S202). The back grinding is performed while the grinder 240 is pressed against the wafer 200. The thickness T1 of the wafer that is obtained after grinding is approximately the same as that of the sensor chip 20, and is in the range of from 200 µm through 400 µm, for example.

Then, the BG tape 220 is irradiated with ultraviolet light so that adhesion of the BG tape 220 is reduced, and then the BG tape 220 is peeled from the wafer 200 (step S203).

Then, the photosensitive resist films 211 and 212 are developed (step S204). As a result, the photosensitive resist pillar 210 is formed on each chip region 209.

Then, the wafer 200 is washed and dried (step S205). For example, pure water is used for washing. A spin dryer is used for drying, for example.

Then, hard baking of the wafer 200 is performed (step S206). By hard baking, moisture remaining in the wafer 200, as well as solvents remaining in the pillars 210, are removed.

In such a manner, the wafer 200 in which the plurality of pillars 210 are on the surface 200A is obtained. The pillars 210 are formed in the device region 201.

The wafer 200 is then diced to be separated into a plurality of chip regions 209 (step S207).

In such a manner, sensor chips 20 including multiple pillars 210 are manufactured.

Other configurations are similar to those described in the first embodiment.

In the second embodiment, in step S202, the back side 200B of the wafer 200 is grinded prior to forming of the pillars 210 in step S204. In this case, a space to be formed with the pillar 210 is not formed between the BG tape 220 and the stage 230, and thus deflection of the wafer 200 is mitigated. In such a manner, the in-plane wafer uniformity of pressure that acts on the wafer 200 through the grinder 240 is approximately obtained. Therefore, the in-plane wafer uniformity of the thickness for the wafer 200, which is obtained after the back grinding, is increased excellently.

Hereafter, with use of actual measured values, the effect obtained in the second embodiment will be described by being compared with that obtained in the reference example.

In a third example according to the second embodiment, for a given wafer, the thickness was 625 µm, and the diameter was 6 inches (15.24 cm). In the back grinding in step S202, a target thickness C of the wafer that was obtained after the back grinding was set to 332 µm.

In a reference example (fourth example), after exposure (step S109) was performed, (i) development, (ii) washing, (iii) drying, and (iv) hard baking (steps S204 to 206) were performed, prior to step S201 to S203, i.e., attachment of the BG tape, grinding of the back side, and peeling of the BG tape. In the back grinding in step S202, a target thickness D of the wafer that was obtained after the back grinding was set to 464 µm. Other conditions were the same as those described in the third example.

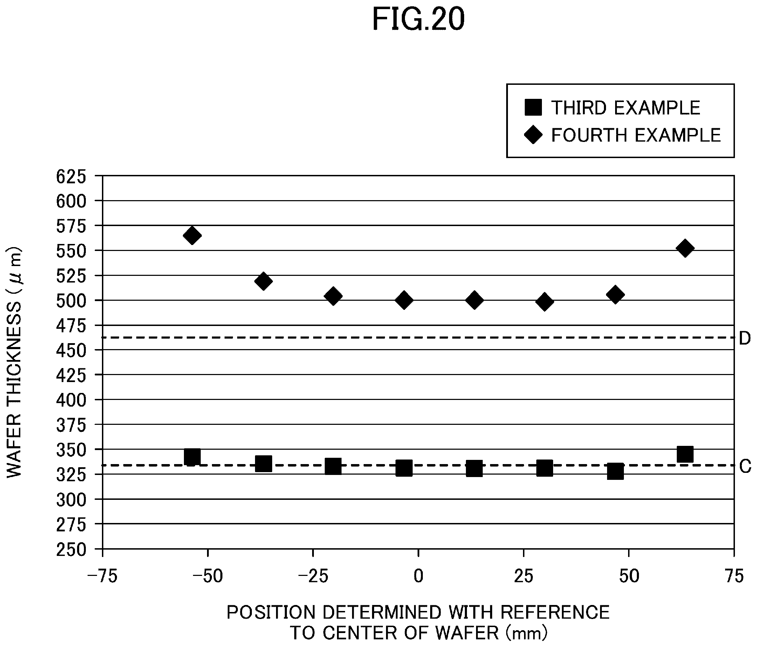

In each of the third example and the fourth example, the thickness of the wafer that was obtained after the back grinding was measured. The result is illustrated in Fig. 20. In Fig. 20, the horizontal axis expresses the position determined with reference to the center of the wafer, and the vertical axis expresses the wafer thickness. A negative value in the horizontal axis corresponds to the position in a direction opposite to a positive direction.

As illustrated in Fig. 20, in the third example (see "■"), a difference between a maximum value and a minimum value was only 18 µm. In contrast, in the fourth example (see "◆"), a difference between the maximum value and the minimum value was 67 µm, which was greater than that obtained in the third example.

Although the preferred embodiments have been described, various modifications and substitutions can be made to the embodiments without departing from the scope defined in the present disclosure.

Manners of the present disclosure are listed below.

### [Manner 1]

A method for manufacturing a semiconductor device, the method comprising:
providing a wafer that includes (i) a device region including a plurality of device regions and (ii) a peripheral region of the device region;
forming a protective layer on one surface of the wafer;
gliding another surface of the wafer in a state in which the protective layer is formed on the one surface of the wafer,
wherein the providing of the wafer includes
   providing a photosensitive resist film on the one surface of the wafer, and
   exposing the photosensitive resist film, and
wherein the method further includes, after the gliding of the another surface of the wafer, forming a pillar on the one surface of the wafer, for each of the chip regions, by developing the photosensitive resist film.

### [Manner 2]

The method for manufacturing the semiconductor device in the first manner, further comprising: after the forming of the pillar,
dicing the wafer to form a plurality of semiconductor chips;
forming a molding resin with which the semiconductor chips, such that a portion of the pillar is exposed on the molding resin; and
removing the pillar.

### [Manner 3]

The method for manufacturing the semiconductor device in the first manner or the second manner, wherein a material of the pillar includes a novolac-based resin, an acrylic-based resin, or a polyimide-based resin.

### [Manner 4]

The method for manufacturing the semiconductor device in any one of the first manner to the third manner, wherein a height of the pillar is greater than or equal to 50 µm and less than or equal to 500 µm.

## Claims

1. A method for manufacturing a semiconductor device, the method comprising:
providing a wafer that includes a device region and a peripheral region of the device region, the device region including multiple chip regions;
removing a portion of the peripheral region such that the removed portion has an annular shape;
forming a protective layer on a first surface of the wafer; and
grinding a second surface of the wafer in which the protective layer is formed on the first surface.

2. The method according to claim 1, wherein the providing of the wafer includes forming a pillar on the first surface, for each of the multiple chip regions.

3. The method according to claim 2, wherein the forming of the pillar includes
providing a photosensitive resist film on the first surface,
exposing the photosensitive resist film, and
developing the exposed photosensitive resist film.

4. The method according to claim 2, wherein the forming of the pillar includes
providing a non-photosensitive film on the first surface,
forming a mask on the non-photosensitive film, and
processing the non-photosensitive film into a pillar shape by using the mask, the pillar shape including pillars.

5. The method according to any one of claims 2 to 4, further comprising, after the grinding of the second surface of the wafer,
dicing the wafer to form multiple semiconductor chips;
forming a molding resin with which the multiple semiconductor chips are sealed, such that a portion of each of pillars is exposed, and
removing the pillars.

6. The method according to any one of claims 2 to 5, wherein a distance between an edge of the wafer, in which the portion of the peripheral region is removed, and a given pillar that is closest to the edge of the wafer and is among multiple pillars, is greater than or equal to 1.0 times and less than or equal to 5.0 times a height of the given pillar.

7. The method according to any one of claims 2 to 6, wherein a material of the pillar includes a novolac-based resin, an acrylic-based resin, or a polyimide-based resin.

8. The method according to any one of claims 2 to 7, wherein a height of the pillar is greater than or equal to 50 µm and less than or equal to 500 µm.

9. The method according to any one of claims 1 to 8, wherein the protective layer contacts the peripheral region over the entire perimeter of the wafer.

10. The method according to any one of claims 1 to 9, wherein the wafer includes an orientation flat in the peripheral region, and
wherein an edge of the wafer obtained after the portion of the peripheral region is removed is located at the orientation flat, or closer to the center of the wafer than the orientation flat.
